# EUROPEAN PATENT SPECIFICATION

(11) **EP 3 091 365 B1**
(45) Date of publication and mention of the grant of the patent: **25.03.2020**
(21) Application number: 15166908.2
(22) Date of filing: 08.05.2015
(51) Int. Cl.: G01R 35/00, G01R 31/28, G01R 27/28

(54) **METHOD FOR ANALYZING THE RF PERFORMANCE OF A PROBE CARD, DETECTOR ASSEMBLY AND SYSTEM FOR ANALYZING THE RF PERFORMANCE OF A PROBE CARD**
VERFAHREN ZUR ANALYSE DER HF-LEISTUNG EINER TESTKARTE, DETEKTORANORDNUNG UND SYSTEM ZUR ANALYSE DER HF-LEISTUNG EINER TESTKARTE
PROCÉDÉ PERMETTANT D'ANALYSER LA PERFORMANCE RF D'UNE CARTE DE SONDE, ENSEMBLE DÉTECTEUR ET SYSTÈME PERMETTANT D'ANALYSER LA PERFORMANCE RF D'UNE CARTE DE SONDE

(43) Date of publication of application: 09.11.2016
(73) Proprietor: Aps Solutions GmbH, 82178 Puchheim (DE); BE Precision Technology, 8071 SC Nunspeet (NL)
(72) Inventor: O'Neil, Paul, East Essex BN22 8UB (GB); Ochsenkuehn, Hanns-Georg, 92318 Neumarkt in der Oberpfalz (DE); Beijert, Oscar, 8075 Bl Elspeet (NL)
(74) Representative: Müller Hoffmann & Partner

(56) References cited:
- US-A1- 2007 182 424
- US-A1- 2010 213 960
- US-A1- 2012 169 359
- US-A1- 2012 169 367

## Description

### BACKGROUND

In the manufacture of semiconductor devices such as integrated circuits, generally, the single components of the semiconductor devices are manufactured on a wafer-level. After the manufacture of the single devices has been completed, the components and the semiconductor devices are tested. For example, integrated circuit may be tested for functional defects by applying special test patterns to the integrated circuit. After testing, the wafer is diced into single dies and the functioning dies are further packaged and sold.

Usually, probe cards are used for testing the components and the semiconductor devices. In particular, the probe cards serves as an electro-mechanical interface between the component to be tested and the testing apparatus. As there is a growing requirement for RF components and devices, the need to characterize the RF performance of a probe card increases.

The performance and the electrical characteristics of the probe cards are important for assessing the real characteristics of the components to be tested. Accordingly, there is a need for a method and a system for measuring and quantifying the RF performance of a probe card.

US 2007/0182424 refers to a high frequency circuit analyser for measuring the response of an electronic device to an RF input signal from a signal generator. US 2010/0213960 refers to a probe card test apparatus and method.

### SUMMARY

It is an object of the present invention to provide an improved method, detector assembly and system for measuring the characteristics of a probe card. According to the present invention, the above object is achieved by the claimed matter according to the independent claims. Further developments are reflected in the dependent claims.

The accompanying drawings are included to provide a further understanding of embodiments of the invention and are incorporated in and constitute a part of this specification. The drawings illustrate the embodiments of the present invention and together with the description serve to explain the principles. Other embodiments of the invention and many of the intended advantages will be readily appreciated, as they become better understood by reference to the following detailed description. The elements of the drawings are not necessarily to scale relative to each other. Like reference numbers designate corresponding similar parts.
- Fig. 1: shows a schematic setup of a device for testing a semiconductor wafer during the manufacture of semiconductor devices.
- Fig. 2: shows a schematic system for analyzing a probe card.
- Fig. 3: shows an embodiment of a system for analyzing a probe card.
- Fig. 4: shows a further embodiment of a system for analyzing a probe card.
- Fig. 5A: summarizes a method according to an embodiment.
- Fig. 5B: summarizes a further method according to an embodiment.

Those skilled in the art will recognize additional features and advantages upon reading the following detailed description and on viewing the accompanying drawings.

### DETAILED DESCRIPTION

In the following detailed description reference is made to the accompanying drawings, which form a part hereof and in which are illustrated by way of illustration specific embodiments in which the invention may be practiced. In this regard, directional terminology such as "top", "bottom", "front", "back", "leading", "trailing" etc. is used with reference to the orientation of the Figures being described. Since components of embodiments of the invention can be positioned in a number of different orientations, the directional terminology is used for purposes of illustration and is in no way limiting. It is to be understood that other embodiments may be utilized and structural or logical changes may be made without departing from the scope defined by the claims.

The description of the embodiments is not limiting. In particular, elements of the embodiments described hereinafter may be combined with elements of different embodiments.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

As employed in this specification, the terms "coupled" and/or "electrically coupled" are not meant to mean that the elements must be directly coupled together - intervening elements may be provided between the "coupled" or "electrically coupled" elements. Likewise, the term "connected" is not meant to mean that the elements must be directly connected together - intervening elements may be provided between the "connected" elements. The term "electrically connected" intends to describe a low-ohmic electric connection between the elements electrically connected together.

The terms "lateral" and "horizontal" as used in this specification intends to describe an orientation parallel to a first surface of a semiconductor substrate or semiconductor body. This can be for instance the surface of a wafer or a die.

The term "vertical" as used in this specification intends to describe an orientation which is arranged perpendicular to the first surface of the semiconductor substrate or semiconductor body.

The term "mechanically coupled" as used in this specification intends to describe that there exists an approximately fixed local relationship between a first element and a second element, when the first element and the second element are mechanically coupled. For example, this may be achieved by mounting or attaching the first element to the second element. Further, the first element and the second element may be directly or indirectly attached to a common support member. According to a further implementation, there may be a rigid interconnection element providing a mechanically coupling between the first and the second element. As is to be readily understood, the mechanically coupling may be implemented in any arbitrary manner to provide an approximately fixed local relationship.

The term "radio frequency (RF)" generally relates to frequencies larger than 1 kHz. In particular, this terms refers to electromagnetic waves having a frequency larger than 1 kHz, for example 3 kHz to 300 GHz.

Signals, in particular "radio frequency signals" may comprise power signals. A power signal may be represented by the product of the time-dependent voltage and the time-dependent current. Usually, any of these signals may be represented by magnitude (or level) and phase. Alternatively, any of these signals may be represented by real part and imaginary part. Further examples of radio frequency signals may comprise electrical and magnetic field strength.

A signal generator may generate various types of periodical signals, e.g. at a fixed frequency. For example, the signal generator may generate cw ("continuous wave") signals or pulsed signals. The signal generator may generate a pure sine or a pure cosine wave at a fixed frequency. The frequency may be changed.

The term "computer" by relate to any processor-based computing entity or other device configured to process digital data, for example digital signals. Examples comprise personal computers, notebooks, personal digital assistants and any other device that is configured to process input signals or values and to output a result. For example, the computer may be integrated in the signal generator or with any other appropriate device or component of the described systems.

The term "receive a signal" as used herein is intended to comprise the case that a first component is connected to a second component so that the signal may be transmitted from the first component to the second component and vice versa.

The term "a first component is attached to a second component" does not necessarily mean that the first component and the second component are in physical contact. Intervening elements may be disposed between the first component and the second component.

As used within the context of the present specification the term "probe card" refers to an electro-mechanical interface between a test system and an electric component to be tested such as a semiconductor device or a semiconductor wafer. The probe card provides an electrical contact between the tester and the device to be tested. For example, a plurality of contact pads or bumps may be disposed on either side of the probe card. The probe card may comprise a printed circuit board and contact elements. For example, a plurality of pins may be disposed at a surface that will be in contact to the device to be tested. Further, the contacts disposed on the side adjacent to the tester may have a larger pitch so as to enable connectors to be connected.

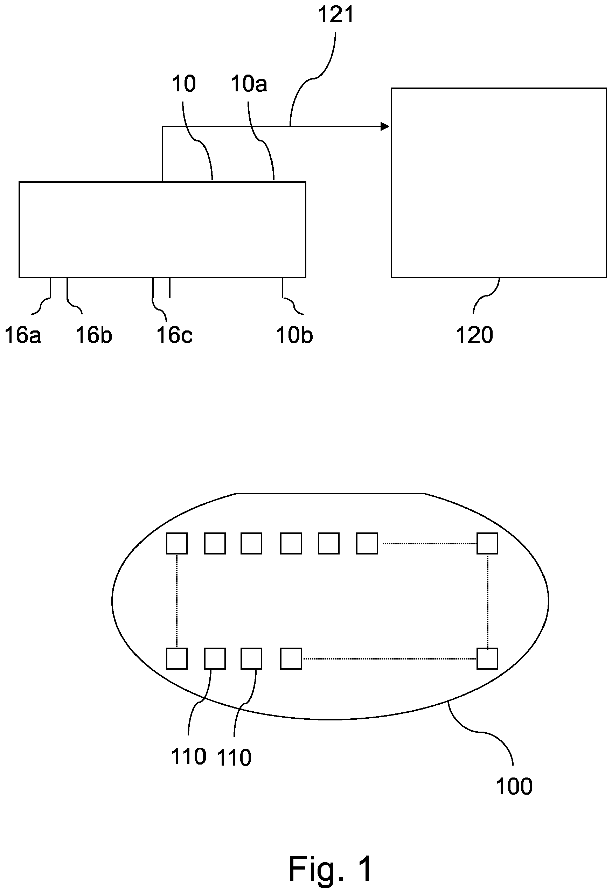

Fig. 1 schematically illustrates an experimental setup for performing a wafer test. The semiconductor wafer 100 comprises a plurality of single dies 110, each including an integrated circuit, a semiconductor device or other electric component. A probe card 10 includes a plurality of output pins 16a, 16b, 16c disposed on a second side 10b of the probe card. A first side 10a of the probe card is connected via a connection line 121 to a tester 120. The tester 120 applies electrical signals to the first side of the probe card 10 and measures the electrical characteristics of the single dies 110. For example, the probe card 10 may be configured to measure a plurality of dies 110 simultaneously. After measuring one or more dies 110, the wafer 100 may be moved and the next dies will be tested.

Since semiconductor based elements increasingly are used in high frequency applications such as data transmission, e.g. in mobile phones and others, there is a need of testing the dies with respect to their radio frequency properties. For example, these measurements may be made by inputting RF signals into the single dies and assessing the electrical characteristics in dependency from the frequencies. Usually, these RF signals are input via the probe card.

Accordingly, in order to achieve significant measurement results, it is desirable to know the RF characteristics of the probe card. Further, during use of the probe cards, after maintenance of the probe card the electrical characteristics of the probe cards may alter. Accordingly, there is also a need for continuously monitoring the electrical characteristics of the probe card with respect to their RF behaviour. Whilst existing metrology tools are able to measure the mechanical and basic (DC) electrical properties of a probe card, nothing seems to exist to determine the RF performance of key signal pins on the probe card.

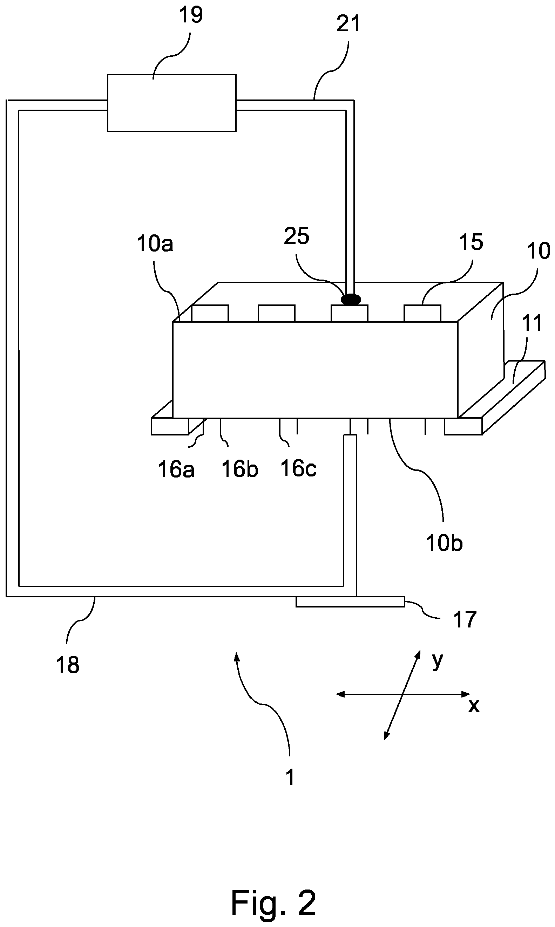

Fig. 2 shows an example of a system for analyzing the probe card 10. The probe card comprises a plurality of RF input connectors 15 that are disposed on a first surface 10a of the probe card. Further, the probe card comprises a plurality of pins 16a, 16b, 16c at the second surface 10b of the probe card. A system for analyzing a probe card comprises a network analyzer 19 and a support member 17. An RF chuck 14 is attached to a support member 17. The RF chuck 14 may receive RF signals from a pin 16 of the probe card 10. The probe card 10 is supported by a carrier 11. For example, the carrier 11 is configured to support the edge portions of the probe card 10 so as to leave the pins 16a, 16b, 16c uncovered. The network analyzer 19 is connected via an RF cable 21 such as a coaxial cable to a connector 25 that is connected to the RF input connector 15. The network analyzer 19 outputs a radio frequency signal via the RF cable to the RF input 15. The signal that has been transmitted by the probe card 10 is received by the RF chuck 14. Then the signal is fed via the RF cable 18 to the network analyzer 19.

The support member 17 may be movable so as to connect the RF chuck 14 with any of the pins at the second side 10b of the probe card 10.

Usually, when assessing the RF characteristics of a device under a test (DUT), the scattering parameter S is determined. In particular, the radio frequency signal is input as a wave having amplitude and phase. Amplitude and Phase of the input waves, the transmitted waves and the reflected waves are determined. The respective signals are fed from the connector 25 to the network analyzer 19 and from the RF chuck 14 to the network analyzer 19. The network analyzer analyzes the amplitude and phase (or the real part and the imaginary part) of the transmitted, reflected and input waves and determines the various S parameters.

As a result, the RF characteristics of the probe card may be determined.

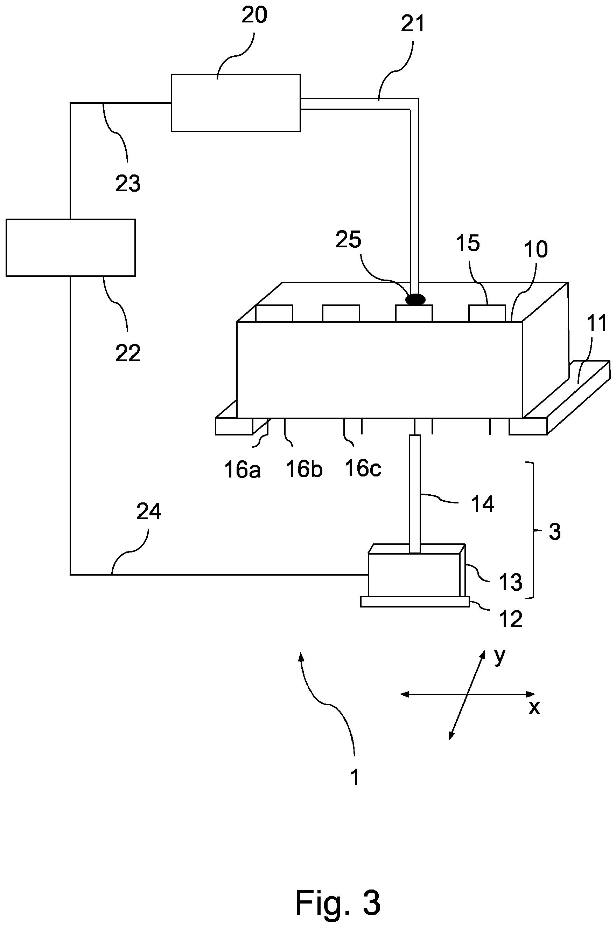

Fig. 3 shows a system 1 for analyzing an RF performance of a probe card 10 according to an embodiment. The system 1 comprises a detector assembly 3. The detector assembly comprises a RF chuck 14. The RF chuck 14 is configured to receive a periodical signal from the probe card. The detector assembly 3 further comprises a sensor 13. The sensor 13 is mechanically coupled to the RF chuck 14 and is configured to receive a periodical signal, e.g. a radio frequency signal from the RF chuck 14. The sensor 13 is configured to measure a magnitude of the periodical signal and to output a measurement signal that represents only the magnitude of the transmitted signal. Generally, RF signals are characterized by their vector properties, e.g. magnitude and phase (or real part and imaginary part). The sensor 13 described herein only outputs the magnitude and neglects the phase. The term "RF chuck" refers to a radio frequency connector element that is configured to electrically connect e.g. the pin 16 at the second surface 10b of the probe card to a connection line for transmitting the radio frequency signal. For example, the connection line may be implemented as a coaxial cable. The RF chuck 14 may comprise an inner portion (core) and an outer shielding material, both comprising a conductive material. For example, the core may be electrically connected to a pin 16 that is to be measured, and the shielding material be electrically connected to ground pins.

The system further comprises a signal generator 20 that is adapted to generate a radio frequency test signal. For example, the signal generator 20 may generate a power signal. The power signal may be output as a CW signal. For example, the signal generator may generate a pure sine wave. The signal generated by the signal generator is input into the probe card 10. For example, the system further comprises a connector 25 for inputting into the probe card 10 the periodical test signal. The connector 25 may be connected to the RF cable 21. Accordingly, the test signal is transmitted via the RF cable 21 to the connector 25 to the probe card 10. The test signal may have a certain magnitude or level, e.g. power magnitude or power level. The power level may be measured in dBm. In particular, this is an abbreviation for the power ratio in decibels (dB) of the measured power referenced to one milliwatt (mW). For example, a power level of 0 dBm corresponds to a power of 1 milliwatt.

The system may further comprise a processing element 22. For example, the processing element 22 or control element may comprise a computer. Further the signal generator 20 may be connected via a further connection line 23 to the processing element 22. The further connection line 23 may be implemented in a similar manner as the connection line 24. The processing element 22 may be configured to receive an output signal of the signal generator 20. The output signal may only indicate a magnitude of the test signal. Further, the measurement signal received by the processing element 22 also measures only the magnitude of the transmitted signal. The processing element 22 may evaluate the electrical characteristics of the probe card 10 based on the output of the signal generator 20 and the measurement signal output by the sensor 13. For example, the signal generated by the signal generator may be a power signal. Accordingly, the processing element 22 may determine a ratio of input power to transmitted power which has been measured by the sensor 13. As a result, the magnitude of probe card losses may be obtained.

The processing element may further be configured to control a frequency of the test signal that is generated by the signal generator 20. Accordingly, the ratio of transmitted power by input power may be determined in dependency from the frequency. For example, a frequency range of this measurement may be approximately 10 MHz to 6 GHz or more, e.g. 8 or 10 GHz. The frequency may be changed at steps of 10 MHz. As is to be readily appreciated, the frequency range may vary, e.g. depending on the range of frequencies for performing the wafer test. From these electrical characteristics, the RF characteristics of the probe card may be determined. For example, the ratio of input power to transmitted power may be determined so as to obtain the power losses in dependency from frequency.

According to an implementation, measurements of a calibration probe card may be used as a calibration value. According to an embodiment, if it is determined that there is a large deviation between the RF characteristics of a measured probe card and the calibration probe card, the measured probe card may be rejected or may be subjected to repair. In more detail, by comparing the RF characteristics of the measured probe card with those of a calibration probe card, it may be determined whether the probe card complies with the requirements or should be rejected or be subjected to repair.

Generally, the processing element may be further being configured to compare the measurement signal with a calibration measurement signal obtained from a calibration probe card. According to an embodiment, the system may be further configured to derive the magnitude in dependency from the frequency to obtain an RF characteristic. According to an embodiment, the system may be further configured to compare the characteristic with a calibration characteristic obtained from a calibration probe card.

The RF chuck 14 and the sensor 13 may be attached to a support member 12. The support member 12 is movable so that the RF chuck 14 may be moved to any desired position of the probe card. For example, the RF chuck 14 may be moved so as to be connected to any of the pins 16a, 16b, 16c. The support member 12 may be movable in a horizontal plane, e.g. parallel to an x- and y-direction. Moreover, the support member 12 may be movable in a vertical direction, e.g. the z-direction. The particular way of moving the support member 12 may be depend on the properties of the probe card analyzer. Accordingly, by moving the support member 12, the probe card 10 may be analyzed using selected ones of the pins 16a, 16b, 16c. According to the embodiment, RF chuck 14 and sensor 13 may be moved when the support member 12 is moved. As a result, individual signal paths of the probe card 10 may be tested.

Due to the fact that the sensor 13 outputs a measurement signal that represents only the magnitude of the transmitted or measured signal, the connection line 24 need not be a RF cable but may be a normal data connection such as a USB ("universal serial bus") data path. Further, since the signal transmitted by the connection line 24 is not an RF signal, the length of the cable and the topology of the cable does not largely influence the measurement. For example, the connection line 24 may be a cable comprising a USB ("universal serial bus") interface. In particular, the movable parts of the system are no longer connected to an RF cable which further increases the reliability and reproducibility of the results. Moreover, the transmitted signal is measured by the sensor 13 that is mechanically coupled to the RF chuck. Due to the fact that the sensor 13 is mechanically coupled to the RF chuck, the signal path, e.g. the length thereof, may not depend on the position of the RF chuck 14, the specific pin to be measured or the position of the sensor and thus does not substantially influence the measurement result. As a result, the measurement results will become more reliable and reproducible. Further, the system illustrated employs comparably cheap instruments such as a signal generator 20 and the sensor 13 which are much cheaper than a network analyzer according to the example shown in Fig. 2. Further, difficulties during calibration of a network analyzer according to the example shown in Fig. 3 may arise, in particular, when employing a SOLT calibration, comprising a well-defined short, open, load, and through (thru) connection for performing measurements. According to the system described herein, these difficulties may be avoided, resulting in a more reliable and reproducible measurement.

As the inventors found out, the probe card may be regarded as a passive structure. Accordingly, the phase information may be regarded as not being crucial for assessing the RF characteristics of the probe card. Therefore, the phase may be neglected and measuring only the magnitude of the transmitted signal, in particular, the magnitude of the transmitted signal in dependence from frequency is sufficient for assessing the RF characteristics of the probe card.

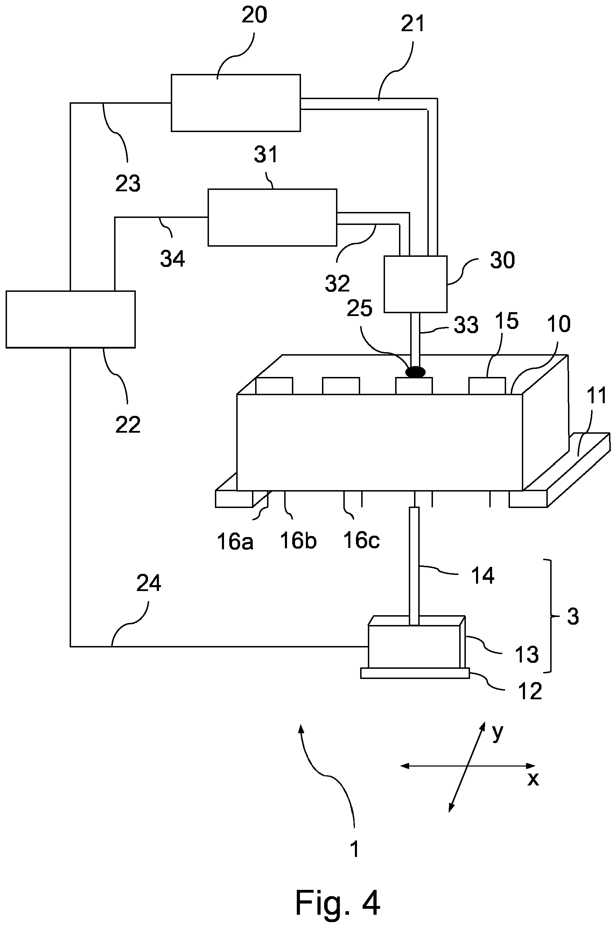

Fig. 4 shows a further embodiment of a system for analyzing a probe card. In addition to the elements shown in Fig. 3, the system of Fig. 4 further comprises a second sensor 31 that is configured to measure a signal that has been reflected by the probe card. The second sensor 31 may be coupled via a directional coupler 30 to the RF cable. For example, a directivity of the second sensor 31 may be larger than 40 dB. In a similar manner as the sensor 13 also the second sensor 31 outputs a measurement signal that represents only the magnitude of the reflected signal. The measurement signal generated by the sensor 31 is output via a sensor connection line 34 to the processing element 22. The sensor connection line 34 may be an ordinary cable since the signal is represented only by the magnitude. The processing element 22 may further evaluate the measurement signal output by the second sensor 31. Due to the presence of the second sensor 31 further characteristics of the probe card 10 may be determined. In particular, the reliability of the measurements may be improved. For example, short circuited signal paths may be detected. Further failure analysis may be performed.

As has been described herein above, the system may be implemented in a simple manner using comparably cheap instruments. Accordingly, the system may be easily integrated within known probe card analyzers and measurements may be effected in a wafer testing environment. In particular, the probe cards may be analyzed in-situ, without sending them to an external testing facility. The processing element 22 may include a storage which stores data for calibrating the RF chuck 14 and measurement data of calibration probe cards.

As has been illustrated in Figs. 3 and 4, a system 1 for analyzing a probe card 10 comprises a signal generator 20 that generates a RF test signal. The RF test signal is fed to a front side terminal of the probe card 10 and transmitted by the probe card 10. A sensor 13 is connected to a back side terminal of the probe card 10 and receives the transmitted signal. The sensor outputs a measurement signal that represents only the magnitude of the transmitted signal. The measurement signal may be fed to a processing element 22 that also receives an output from the signal generator. The output from the signal generator 20 may also only represent a magnitude. From a comparison of the measurement signal and the output from the signal generator that electrical characteristic of the probe card may be determined. For example, the sensor 13 may be a power sensor. For example, the front side terminal may be a RF input connector 15. The back side terminal may be a pin 16. The system may further comprise a second sensor 31 for measuring a reflected signal, as is also illustrated in Fig. 4.

The system 1 for analyzing an RF performance of a probe card as described hereinabove may further comprise elements of known probe card analyzers. In particular, the system 1 for analyzing an RF performance of a probe card may be implemented as a probe card analyzer or as a wafer prober similar to the apparatus shown in Fig. 1. The system 1 for analyzing an RF performance of a probe card may be interpreted as a scalar network analyzer - in comparison to a vector network analyzer which also takes into account the phase of the signal.

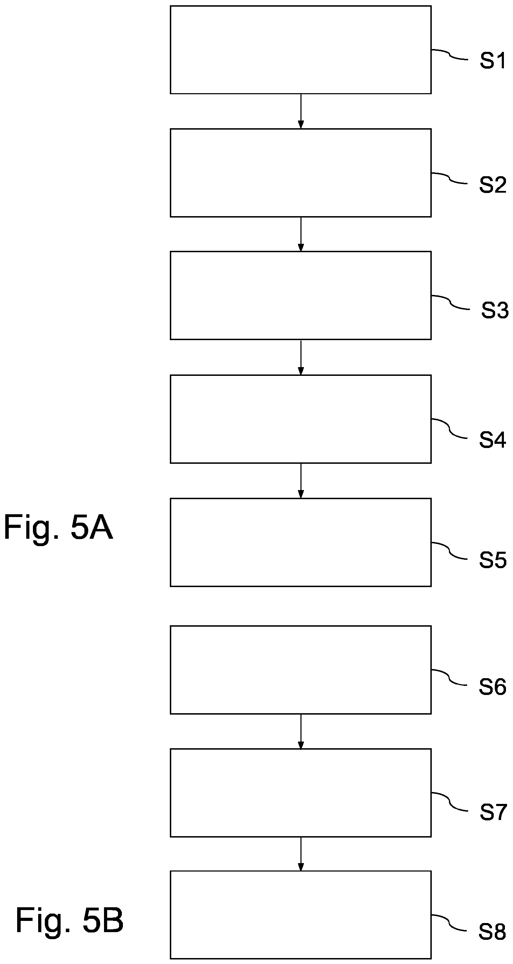

Fig. 5A summarizes a method of analyzing a probe card. The method comprises inputting into the probe card a radio frequency test signal (S1), receiving from the probe card a transmitted signal in response to the inputted radio frequency test signal (S2), measuring a magnitude of the transmitted signal (S3), and outputting a measurement signal (S5) that represents only the magnitude of the transmitted signal. The method may further comprise changing a frequency of the test signal after measuring the magnitude of the transmitted signal. The method may further comprise deriving the magnitude or a signal derived from the measurement signal in dependency from the frequency to obtain a characteristic. According to an embodiment, the method may further comprise comparing the characteristic with a calibration characteristic obtained from a calibration probe card.

According to an embodiment, a computer program product when implemented on a processing element, e.g. a computer may perform the method illustrated in Fig. 5B: causing a radio frequency test signal of known frequency and known power level to be input into a probe card (S6); causing a sensor to receive from the probe card a transmitted signal in response to the inputted radio frequency test signal (S7), and causing the sensor to output a measurement signal that represents only the magnitude of the received signal (S8). The computer program product may further cause the signal generator to generate the respective test signal and further to change a frequency of the test signal after the magnitude of the received signal has been measured.

## Claims

1. A method of analyzing a probe card (10), comprising:
moving a common support member (12) supporting a radio frequency connector element (14) and a sensor (13), so that the radio frequency connector element (14) is connected to a selected pin of the probecard (10),
inputting into the probe card (10) a radio frequency test signal,
receiving from the probe card (10) a transmitted signal in response to the inputted radio frequency test signal,
measuring a magnitude of the transmitted signal,
outputting by the sensor, a measurement signal that represents only the magnitude of the transmitted signal.

2. The method according to claim 1, further comprising changing a frequency of the test signal after measuring the magnitude of the transmitted signal.

3. The method according to claim 1 or 2, further comprising:
receiving a reflected signal, the reflected signal having been reflected by the probe card (10) in response to the inputted radio frequency test signal,
measuring a magnitude of the reflected signal;
outputting a further measurement signal that represents only the magnitude of the reflected signal.

4. The method according to any of claims 1 to 3, further comprising comparing the measurement signal or a signal derived from the measurement signal with a calibration measurement signal obtained from a calibration probe card.

5. The method according to claim 2, further comprising deriving the magnitude or a signal derived from the measurement signal in dependency from the frequency to obtain a characteristic.

6. A detector assembly (3) comprising:
a radio frequency connector element (14) for receiving a radio frequency signal from a probe card (10),
a sensor (13) configured to receive the radio frequency signal from the radio frequency connector element (14),
the sensor (13) being configured to measure a magnitude of the radio frequency signal and to output a measurement signal that represents only the magnitude of the radio frequency signal,
the radio frequency connector element (14) and the sensor (13) being mechanically coupled and being attached to a common support member (12), wherein the common support member (12) is movable so that the radio frequency connector element (14) is configured to be connected to a selected pin of the probe card (10).

7. The detector assembly (3) according to claim 6, wherein the radio frequency signal received by the sensor (13) is a signal transmitted by the probe card (10) in response to an inputted radio frequency test signal,

8. A system (1) for analyzing an RF performance of a probe card (10), comprising:
a signal generator (20) adapted to generate a radio frequency test signal.
a connector (25) for inputting into the probe card (10) the radio frequency test signal; and
the detector assembly (3) according to any of claims 6 to 7,
wherein the radio frequency connector element (14) is configured to receive the radio frequency signal transmitted by the probe card in response to the inputted radio frequency test signal.

9. The system (1) according to claim 8,
wherein the signal generator (20) is adapted to generate a power signal having a fixed frequency.

10. The system (1) according to claim 8 or 9, further comprising a second sensor (31), being configured to receive a reflected signal from the probe card (10), the reflected signal having been reflected by the probe card (10) in response to the inputted periodical test signal.

11. The system according to any of claims 8 to 10, further comprising a processing element (22), the processing element (22) being configured to
receive an output of the signal generator (20) indicating a magnitude of the generated test signal,
receive the measurement signal, and
to evaluate RF characteristics of the probe card (10) based on the magnitude of the generated test signal and the measurement signal.

12. The system (1) according to any of claims 8 to 11, the processing element (20) further being configured to control a frequency of the signal generated by the signal generator.

## Patentansprüche

1. Verfahren zum Analysieren einer Prüfkarte (10), mit:
Bewegen eines gemeinsamen Trägerelements (12), das ein Hochfrequenzanschlusselement (14) und einen Sensor (13) trägt, so dass das Hochfrequenzanschlusselement (14) mit einem ausgewählten Pin der Prüfkarte (10) verbunden wird,
Zuführen eines Hochfrequenztestsignals in die Prüfkarte (10);
Empfangen eines von der Prüfkarte (10) als Antwort auf das zugeführte Hochfrequenztestsignal übertragenen Signals,
Messen eines Betrags des übertragenen Signals,
Ausgeben eines Messsignals, welches nur den Betrag des übertragenen Signals darstellt, durch den Sensor.

2. Verfahren nach Anspruch 1, ferner umfassend das Verändern einer Frequenz des Testsignals nach Messen des Betrags des übertragenen Signals.

3. Verfahren nach Anspruch 1 oder 2, ferner mit:
Empfangen eines reflektierten Signals, wobei das reflektierte Signal von der Prüfkarte (10) als Antwort auf das zugeführte Hochfrequenztestsignal reflektiert worden ist,
Messen eines Betrags des reflektierten Signals,
Ausgeben eines weiteren Messsignals, welches nur den Betrag des reflektierten Signals darstellt.

4. Verfahren nach einem der Ansprüche 1 bis 3, ferner umfassend das Vergleichen des Messsignals oder eines von dem Messsignal abgeleiteten Signals mit einem Kalibrierungsmesssignal, welches von einer Kalibrierungsprüfkarte erhalten worden ist.

5. Verfahren nach Anspruch 2, weiterhin mit dem Ableiten des Betrags oder eines von dem Messsignal abgeleiteten Signals in Abhängigkeit von der Frequenz, um eine Charakteristik zu erhalten.

6. Detektoranordnung (3) mit:
einem Hochfrequenzanschlusselement (14) zum Empfangen eines Hochfrequenzsignals von einer Prüfkarte (10),
einem Sensor (13), welcher ausgebildet ist, um das Hochfrequenzsignal von dem Hochfrequenzanschlusselement (14) zu empfangen,
wobei der Sensor (13) ausgebildet ist, einen Betrag des Hochfrequenzsignals zu messen und ein Messsignal, welches nur den Betrag des Hochfrequenzsignals darstellt, auszugeben,
wobei das Hochfrequenzanschlusselement (14) und der Sensor (13) mechanisch gekoppelt sind und an ein gemeinsames Trägerelement (12) angebracht sind, und das gemeinsame Trägerelement (12) beweglich ist, so dass das Hochfrequenzanschlusselement (14) mit einem ausgewählten Pin der Prüfkarte (10) verbindbar ist.

7. Detektoranordnung (3) nach Anspruch 6, wobei das Hochfrequenzsignal, welches vom Sensor (13) empfangen wird, ein Signal ist, welches von der Prüfkarte (10) als Antwort auf ein zugeführtes Hochfrequenztestsignal übertragen worden ist.

8. System (1) zum Analysieren eines Hochfrequenzverhaltens einer Prüfkarte (10), mit:
einem Signalgenerator (20), welcher geeignet ist, ein Hochfrequenztestsignal zu erzeugen;
einem Anschluss (25) zum Zuführen des Hochfrequenztestsignals in die Prüfkarte (10); und
der Detektoranordnung (3) nach Anspruch 6 oder 7,
wobei das Hochfrequenzanschlusselement (14) ausgebildet ist, um das Hochfrequenzsignal, welches von der Prüfkarte als Antwort auf das zugeführte Hochfrequenztestsignal übertragen worden ist, zu empfangen.

9. System (1) nach Anspruch 8,
wobei der Signalgenerator (20) ausgebildet ist, um ein Leistungssignal mit einer festen Frequenz zu erzeugen.

10. System (1) nach Anspruch 8 oder 9, weiter aufweisend einen zweiten Sensor (31), welcher ausgebildet ist, um ein reflektiertes Signal von der Prüfkarte (10) zu empfangen, wobei das reflektierte Signal von der Prüfkarte (10) als Antwort auf das zugeführte periodische Testsignal reflektiert worden ist.

11. System nach einem der Ansprüche 8 bis 10, weiterhin aufweisend ein Verarbeitungselement (22), wobei das Verarbeitungselement (22) ausgebildet ist, um
ein Ausgangssignal des Signalgenerators (20), welches einen Betrag des erzeugten Testsignals angibt, zu empfangen,
das Messsignal zu empfangen, und
Hochfrequenzeigenschaften der Prüfkarte (10) basierend auf dem Betrag des erzeugten Testsignals und des Messsignals auszuwerten.

12. System (1) nach einem der Ansprüche 8 bis 11, wobei das Verarbeitungselement (20) weiter ausgebildet, um eine Frequenz des Signals, welches vom Signalgenerator erzeugt wird, zu steuern.

## Revendications

1. Procédé pour analyser une carte de test (10), comprenant :
déplacer un organe de support commun (12) supportant un élément connecteur radiofréquence (14) et un capteur (13) de sorte que l'élément connecteur radiofréquence (14) soit relié à une broche sélectionnée de la carte de test (10),
entrer dans la carte de test (10) un signal de test radiofréquence,
recevoir de la carte de test (10) un signal transmis, en réponse au signal de test radiofréquence entré,
mesurer une magnitude du signal transmis,
délivrer par le capteur un signal de mesure qui représente seulement la magnitude du signal transmis.

2. Procédé selon la revendication 1, comprenant en outre changer une fréquence du signal de test après la mesure de la magnitude du signal transmis.

3. Procédé selon la revendication 1 ou 2, comprenant en outre :
recevoir un signal réfléchi, le signal réfléchi ayant été réfléchi par la carte de test (10) en réponse au signal de test radiofréquence entré,
mesurer une magnitude du signal réfléchi ;
délivrer un autre signal de mesure qui représente seulement la magnitude du signal réfléchi.

4. Procédé selon l'une quelconque des revendications 1 à 3, comprenant en outre comparer le signal de mesure ou un signal tiré du signal de mesure avec un signal de mesure d'étalonnage obtenu d'une carte de test d'étalonnage.

5. Procédé selon la revendication 2, comprenant en outre le fait de tirer la magnitude ou un signal tiré du signal de mesure en fonction de la fréquence pour obtenir une caractéristique.

6. Ensemble détecteur (3) comprenant :
un élément connecteur radiofréquence (14) pour recevoir un signal radiofréquence d'une carte de test (10),
un capteur (13) configuré pour recevoir le signal radiofréquence de l'élément connecteur radiofréquence (14),
le capteur (13) étant configuré pour mesurer une magnitude du signal radiofréquence et pour délivrer un signal de mesure qui représente seulement la magnitude du signal radiofréquence,
l'élément connecteur radiofréquence (14) et le capteur (13) étant couplés mécaniquement et étant fixés à un organe de support commun (12), dans lequel l'organe de support commun (12) est mobile de sorte que l'élément connecteur radiofréquence (14) soit configuré pour être relié à une broche sélectionnée de la carte de test (10).

7. Ensemble détecteur (3) selon la revendication 6, dans lequel le signal radiofréquence reçu par le capteur (13) est un signal transmis par la carte de test (10) en réponse à un signal de test radiofréquence entré.

8. Système (1) pour analyser une performance RF d'une carte de test (10), comprenant :
un générateur de signaux (20) adapté pour générer un signal de test radiofréquence,
un connecteur (25) pour entrer dans la carte de test (10) le signal de test radiofréquence ; et
l'ensemble détecteur (3) selon l'une quelconque des revendications 6 à 7,
dans lequel l'élément connecteur radio fréquence (14) est configuré pour recevoir le signal radiofréquence transmis par la carte de test en réponse au signal de test radiofréquence entré.

9. Système (1) selon la revendication 8,
dans lequel le générateur de signaux (20) est adapté pour générer un signal de puissance ayant une fréquence fixe.

10. Système (1) selon la revendication 8 ou 9, comprenant en outre un deuxième capteur (31), étant configuré pour recevoir un signal réfléchi de la carte de test (10), le signal réfléchi ayant été réfléchi par la carte de test (10) en réponse au signal de test périodique entré.

11. Système (1) selon l'une quelconque des revendications 8 à 10, comprenant en outre un élément de traitement (22), l'élément de traitement (22) étant configuré pour
recevoir une sortie du générateur de signaux (20) indiquant une magnitude du signal de test généré,
recevoir le signal de mesure, et
évaluer des caractéristiques RF de la carte de test (10) sur la base de la magnitude du signal de test généré et du signal de mesure.

12. Système (1) selon l'une quelconque des revendications 8 à 11, l'élément de traitement (20) étant en outre configuré pour commander une fréquence du signal généré par le générateur de signaux.
